# DEMANDE DE BREVET EUROPEEN

(11) **EP 1 359 617 A1**
(43) Date de publication de la demande: **05.11.2003**
(21) Numéro de dépôt: 02405347.2
(22) Date de dépôt: 29.04.2002
(51) Int. Cl.: H01L 23/31, H01L 21/56

(54) **Procédé de fabrication de modules électroniques**

(71) Demandeur: Valtronic S.A., 1343 Les Charbonnières (CH)
(72) Inventeur: Zeberli, Jean-Francois, 1347 Le Sentier (CH); Rochat, Michel, 1025 St-Sulpice (CH)
(74) Mandataire: Gresset, Jean

(57) **Abrégé**

L'invention concerne un procédé de fabrication de modules électroniques (32) à partir d'un "wafer" (10) comportant une pluralité de puces électroniques (12) dont une face, dite face active, est dotée de protubérances conductrices (14).

Il comprend les opérations de :
- sciage du "wafer" (10) pour isoler une pluralité de blocs de puces (20),
- report de chaque bloc (20) sur un circuit imprimé doté de plages conductrices et sa liaison, par la face active des puces, de manière à connecter lesdites protubérances (14) auxdites plages, et
- sciage du bloc (20) et du circuit imprimé (22) de manière à séparer les puces (12) et la portion du circuit qui leur correspond.

## Description

L'invention se rapporte au domaine des circuits intégrés, aussi communément appelés puces électroniques. Elle concerne, plus particulièrement, un procédé de fabrication d'un module électronique en mode dit "Flip Chip".

La technique Flip Chip est très bien adaptée à la réalisation de modules électroniques constitués d'une puce et d'un circuit imprimé. La puce est fixée retournée et connectée à des plages de contact ou "pads" formés sur le circuit imprimé par l'intermédiaire de protubérances conductrices ou "bumps" formées sur sa face active.

Dans l'état actuel de la technique, on part d'un disque de silicium, appelé "wafer", dans lequel est formée une pluralité de puces électroniques dotées de "bumps". Ce disque est alors collé sur un support adhésif en matière plastique, appelé "Blue Foil", puis, le "wafer" est scié de manière à séparer les puces les unes des autres, sans entamer le support.

Les puces sont alors séparées une à une du "Blue Foil", retournées et montées en mode Flip-Chip sur un circuit imprimé ou PCB (de l'anglais Printed Circuit Board).

L'opération la plus longue d'un tel procédé est le report et la fixation de chacune des puces, séparément, sur le circuit imprimé. Même si cette opération est effectuée par une machine, celle-ci est mobilisée un temps important pour obtenir un seul module. Les coûts de production s'en trouvent donc relativement élevés.

La présente invention a pour but de fournir un procédé permettant une réduction notable du prix de revient et de la dimension des modules électroniques.

De façon plus précise, l'invention concerne un procédé de fabrication de modules électroniques à partir d'un "wafer" comportant une pluralité de puces électroniques dont une face, dite face active, est dotée de protubérances conductrices. Ce procédé est caractérisé en ce qu'il comprend les opérations de :
- sciage du "wafer" pour isoler une pluralité de blocs de puces,
- report de chaque bloc sur un circuit imprimé doté de plages conductrices et sa liaison, par la face active des puces, de manière à connecter les protubérances aux plages, et
- sciage du bloc et du circuit imprimé de manière à séparer les puces et la portion du circuit qui leur correspond.

Le procédé selon l'invention comporte encore, de préférence, les principales caractéristiques suivantes :
- préalablement à l'opération de sciage du "wafer", il comporte l'opération de collage du "wafer" sur un support "Blue foil", par sa face opposée aux protubérances conductrices, le sciage étant effectué sans entamer ce support,
- la liaison du bloc de puces au circuit imprimé qui comprend le dépôt d'une couche de colle sur le circuit, et l'application du bloc de puces sur le circuit de manière à écraser ses protubérances conductrices sur les plages du circuit, sans interposition de colle,
- préalablement à l'opération de sciage du bloc et du circuit imprimé, il comporte l'opération de collage du bloc sur un support "Blue foil", par la face inactive du bloc de puces, le sciage étant effectué sans entamer ce support.

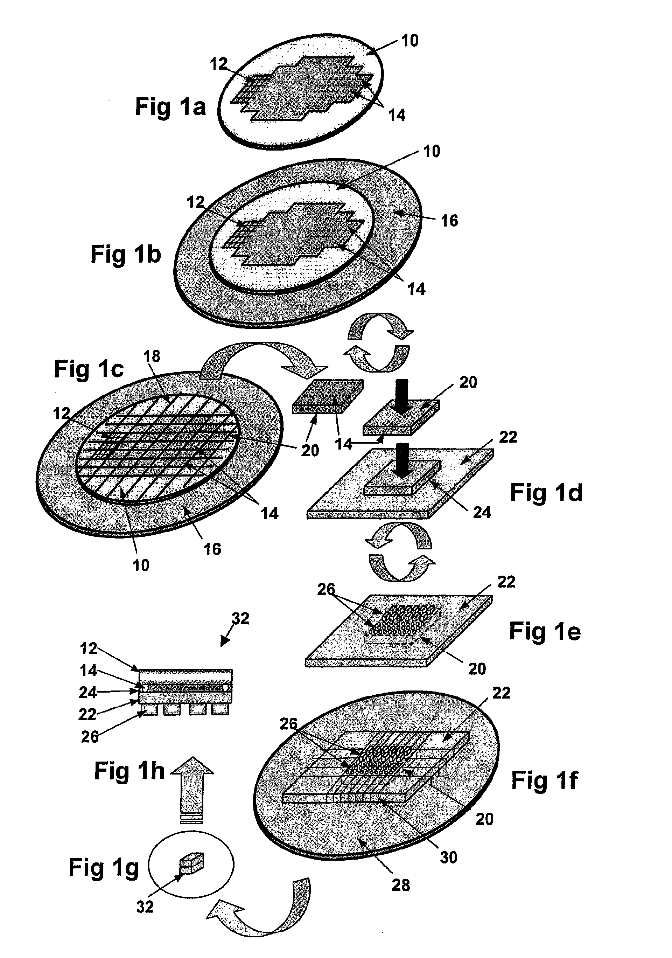

D'autre caractéristiques de l'invention ressortiront de la description qui va suivre, faite en regard des figures 1a à 1h, illustrant les différentes étapes du procédé.

Sur la figure 1a, on a représenté en 10 un disque en matériau semi-conducteur, du silicium par exemple, ou "wafer", ayant typiquement un diamètre de 100 à 300 mm, dans lequel est formée une pluralité de puces ou circuits intégrés 12. La face supérieure des puces, qui constitue leur face active, est dotée, de manière classique, de protubérances conductrices 14, ou "bumps", avantageusement en or.

Comme le montre la figure 1b, le "wafer" 10 est collé, par sa face opposée aux protubérances 14, sur un disque adhésif en matière plastique 16, ou "Blue Foil", destiné à faciliter sa manipulation.

Selon l'invention, ainsi que représenté sur la figure 1c, le "wafer" 10 est préalablement scié, selon un quadrillage 18, de manière à isoler une pluralité de blocs de puces 20. Typiquement, ces blocs ont une forme carrée ou rectangulaire, représentant une subdivision régulière du "wafer" 10. On notera que le disque 16 n'est pas découpé. Ainsi, les blocs 20 sont maintenus en place.

Par un procédé connu de l'homme de métier sous la désignation "Die Sorting", les blocs de puces 20 sont alors extraits un à un du disque support 16 en utilisant, une machine de "Die Sorting" manuelle ou automatique, disponible sur le marché.

Comme illustré schématiquement sur la figure 1d, la machine prélève le bloc 20, le retourne et le dépose selon le mode "Flip Chip", c'est à dire par sa face active comportant les protubérances conductrices 14, sur le substrat d'un circuit imprimé 22 dont la face supérieure est dotée, de manière classique, de plages conductrices non représentées au dessin.

La technique utilisée est bien connue de l'homme de métier et est décrite, par exemple, dans la demande de brevet EP 01810461.2. Une couche de colle 24, en principe non-conductrice, est préalablement répartie sur la surface du circuit imprimé 22. Le bloc de puces 20 y est appliqué, du côté de sa face munie des "bumps" 14. Le tout est porté à une température d'environ 200°C, afin de diminuer la viscosité de la colle. Parallèlement, la machine exerce une pression, proportionnelle au nombre de "bumps", sur la face supérieure des blocs retournés. Les "bumps" 14 sont ainsi écrasés contre les plages conductrices du circuit imprimé 22, la couche de colle 24 entre eux étant uniformément répartie et chassée, de manière à obtenir une interconnexion parfaite, sans qu'aucune bulle d'air ne gêne sa bonne tenue.

La figure 1e montre que, lors de la phase suivante du procédé, l'assemblage est retourné et la face restée libre du circuit imprimé 22 est dotée, selon des procédés connus, d'éléments 26 affectés séparément à chaque puce 12, qui peuvent être des composants SMD ou des boules de soudage.

On remarquera qu'à ce stade, toutes les puces 12 du bloc 20 sont fonctionnellement indépendantes mais physiquement réunies entre elles et au circuit imprimé 22. C'est à ce moment que les vérifications de bon fonctionnement peuvent être conduites sur chacune des puces et que, si nécessaire, des réparations peuvent être faites.

Comme le montre la figure 1f, le bloc 20 est ensuite collé, par la face inactive des puces 12, sur un support adhésif 28, par exemple du même type que le disque "Blue Foil" 16.

Il ne reste plus, alors, qu'à scier l'ensemble sans entamer le disque 28, selon un quadrillage 30, de manière à séparer les puces 12 et la portion de circuit imprimé 22 qui leur correspond exactement, de manière à obtenir une pluralité de modules indépendants 32, mais restant en place sur le disque 28. Ces modules, représentés individuellement sur les figures 1g et 1h, peuvent être alors prélevés séparément, par tout moyen approprié, en vue de leur destination finale.

Ainsi est proposé un procédé permettant de réaliser les opérations les plus longues (transport et fixation des puces à leur circuit imprimé) sur un bloc de puces et non individuellement sur chacune de ces puces. Une économie importante peut donc être réalisée sur les coûts de production des modules.

On notera, par ailleurs, que le procédé permet d'obtenir des modules désignés sous le nom de CSP (Chip Size Package) dans lesquels le circuit imprimé a exactement les mêmes dimensions que la puce. Il en résulte un gain de place notable, difficile à obtenir avec les méthodes de l'art antérieur.

## Revendications

1. Procédé de fabrication de modules électroniques (32) à partir d'un "wafer" (10) comportant une pluralité de puces électroniques (12) dont une face, dite face active, est dotée de protubérances conductrices (14), **caractérisé en ce qu'**il comprend les opérations de :
- sciage du "wafer" (10) pour isoler une pluralité de blocs de puces (20),
- report de chaque bloc (20) sur un circuit imprimé (22) doté de plages conductrices et sa liaison, par la face active des puces, de manière à connecter lesdites protubérances (14) auxdites plages, et
- sciage du bloc (20) et du circuit imprimé (22) de manière à séparer les puces (12) et la portion du circuit (22) qui leur correspond.

2. Procédé selon la revendication 1, **caractérisé en ce que**, préalablement à l'opération de sciage du "wafer" (10), il comporte l'opération de collage dudit wafer sur un support (16), par sa face opposée aux protubérances conductrices (14), le sciage étant effectué sans entamer ce support.

3. Procédé selon l'une des revendications 1 et 2, **caractérisé en ce que** la liaison du bloc (20) au circuit imprimé (22) comprend :
- le dépôt d'une couche de colle (24) sur le circuit, et
- l'application du bloc de puces sur ledit circuit de manière à écraser ses protubérances conductrices (14) sur les plages du circuit, sans interposition de colle.

4. Procédé selon l'une des revendications 1 à 3, **caractérisé en ce que**, préalablement à l'opération de sciage du bloc (20) et du circuit imprimé (22), il comporte l'opération de collage du bloc sur un support (28), par la face inactive du bloc de puces (20), le sciage étant effectué sans entamer ce support.
